# EUROPEAN PATENT APPLICATION

(11) **EP 4 730 978 A1**
(43) Date of publication of application: **22.04.2026**
(21) Application number: 25208547.7
(22) Date of filing: 14.10.2025
(51) Int. Cl.: H10W 20/00, H10D 30/67, H10D 62/10, H10D 84/01, H10D 88/00, H10W 20/41, H10W 20/40, H10W 20/20, H10D 84/85

(54) **SEMICONDUCTOR DEVICE INCLUDING BACKSIDE CONTACT PLUG FOR SIDE VIA STRUCTURE**

(30) Priority: 15.10.2024 US 202463707518 P; 02.05.2025 US 202519197383
(71) Applicant: Samsung Electronics Co., Ltd., Suwon-si, Gyeonggi-do 16677 (KR)
(72) Inventor: CHUNG, Wonkeun, San Jose, CA 95134 (US); SHIN, Jongmin, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Provided is a semiconductor device which includes: a 1^{st} source/drain region (113); a 2^{nd} source/drain region (123) above the 1^{st} source/drain region (113); a side via structure (217) connected to the 2^{nd} source/drain region (223); a 1^{st} backside contact plug (104) on the 1^{st} source/drain region (113); a 2^{nd} backside contact plug (205) on the side via structure (217); a 1^{st} backside metal line (109A) on the 1^{st} backside contact plug (104); a 2^{nd} backside metal line (109B) on the 2^{nd} backside contact plug (205); and a 1^{st} deep trench isolation structure (203) on a side surface of the 2^{nd} backside contact plug (205).

## Description

### BACKGROUND

### 1. Field

Apparatuses and methods consistent with the disclosure relate to a stacked semiconductor device in which a backside contact plug for a side via structure is buried in a placeholder structure.

### 2. Description of Related Art

A stacked field-effect transistor (FET) device has been introduced in response to increased demand for a semiconductor device having a high device density and performance. The stacked semiconductor device may include a 1^{st} FET at a 1^{st} level and a 2^{nd} FET at a 2^{nd} level above the 1^{st} level, where each of the two FETs may be a fin field-effect transistor (FinFET), a nanosheet transistor, a forksheet transistor, or any other types of FET. The stacked semiconductor device formed of the FinFETs, nanosheet transistors, or forksheet transistors may also be referred to as a three-dimensional stacked (3D-stacked) semiconductor device.

The FinFET has one or more fin structures, which are protruded from a substrate, as a channel structure and a gate structure surrounding at least three surfaces of each of the fin structures. The nanosheet transistor is characterized by one or more nanosheet channel layers, which are vertically stacked or arranged on a substrate, as a channel structure and a gate structure surrounding all four surfaces of each of the nanosheet channel layers. The nanosheet transistor is referred to as a gate-all-around (GAA) transistor or a multi-bridge channel field-effect transistor (MBCFET). The forksheet transistor is a combination of two nanosheet transistors with an isolation wall therebetween. In the forksheet transistor, nanosheet channel layers of each nanosheet transistor are formed at each side of the isolation wall and pass through a gate structure in parallel with the isolation wall.

In addition to the stacked semiconductor device, a backside power distribution network (BSPDN) structure formed at a back side of a semiconductor device has been introduced to address a heavy traffic of signal lines and power rails, high device density, and increased contact resistance between structural elements of the stacked semiconductor device at a front side of the semiconductor device. Here, the front side refers to a side where a transistor structure including a channel structure, a gate structure, and source/drain regions is formed with respect to a substrate of the semiconductor device, and the back side refers to a side opposite the front side. The BSPDN structure may include backside metal lines such as a buried power rail connected to a voltage source and a buried signal line connected to another circuit element. Further, the BSPDN structure may include backside contact plugs connecting active elements, such as source/drain regions, of the semiconductor device to the buried power rails or signal lines through the back side of the semiconductor device. The BSPDN structure may be more useful to the stacked semiconductor devices.

The stacked semiconductor devices may be implemented in a standard cell and manufactured based on a layout of the semiconductor cell. However, as the cell height of the standard cell including the stacked semiconductor devices becomes smaller to respond to the increased demand for high-density semiconductor devices, formation of the backside contact plugs connecting the source/drain regions of the stacked semiconductor devices to the buried power rails or signal lines exposes various risks including increased contact resistance and misaligned connections between device elements.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a stacked semiconductor device in which a fill frontside contact plug is formed to contact a side surface of an upper source/drain region and a side spacer formed on a side surface of a lower source/drain region to be isolated from the lower source/drain region. This fill frontside contact plug may be formed in a semiconductor device with a reduced cell height in a simplified process.

According to an aspect of the disclosure, there is provided a semiconductor device which may include: a 1^{st} source/drain region; a 2^{nd} source/drain region above the 1^{st} source/drain region; a side via structure connected to the 2^{nd} source/drain region; a 1^{st} backside contact plug on the 1^{st} source/drain region; a 2^{nd} backside contact plug on the side via structure; a 1^{st} backside metal line on the 1^{st} backside contact plug; and a 2^{nd} backside metal line on the 2^{nd} backside contact plug.

According to an aspect of the disclosure, the semiconductor device may further include a deep trench isolation structure on a side surface of the 2^{nd} backside contact plug.

According to an aspect of the disclosure, there is provided a semiconductor device which may include: a source/drain region; a backside contact plug on a bottom surface of the source/drain region; and a deep trench isolation structure on a side surface of the backside contact plug.

According to an aspect of the disclosure, the semiconductor device may further include a shallow trench isolation (STI) structure above the 1^{st} deep trench isolation structure, wherein the STI structure is also on the side surface of the backside contact plug.

According to an aspect of the disclosure, there is provided a method of manufacturing a semiconductor device, which may include: forming a 1^{st} source/drain region and a 2^{nd} source/drain region above the 1^{st} source/drain region; forming a side via structure connected to the 2^{nd} source/drain region; forming a 1^{st} backside contact plug on the 1^{st} source/drain region; forming a 2^{nd} backside contact plug on the side via structure; forming a 1^{st} backside metal line on the 1^{st} backside contact plug; and forming a 2^{nd} backside metal line on the 2^{nd} backside contact plug.

### BRIEF DESCRIPTION OF DRAWINGS

Example embodiments of the disclosure will be more clearly understood from the following detailed description taken in conjunction with the accompanying drawings.
FIG. 1A illustrates is a layout of a semiconductor cell in which a semiconductor device including a side via structure and backside contact plugs for source/drain regions is formed, according to one or more embodiments, FIG. 1B is a cross-section view of the semiconductor cell taken along a line I-I' shown in FIG. 1A, according to one or more embodiments, and FIG. 1C is a schematic of an inverter circuit implemented by the stacked semiconductor device of FIGS. 1A and 1B, according to one or more embodiments.
FIG. 2 illustrates a semiconductor devices including backside contact plugs for source/drain regions and a side via structure, according to one or more embodiments.
FIG. 3 illustrates a semiconductor devices including backside contact plugs for source/drain regions and a side via structure, according to one or more other embodiments.
FIG. 4 illustrates a semiconductor devices including backside contact plugs for source/drain regions and a side via structure, according to still one or more other embodiments.
FIGS. 5A-5N illustrate intermediate semiconductor devices obtained after respective steps of manufacturing the semiconductor device 200 as shown in FIG. 2 which includes backside contact plugs for source/drain regions and a side via structure, according to one or more embodiments.
FIGS. 6A and 6B are a flowchart of manufacturing the semiconductor device 200 as shown in FIG. 2 which includes backside contact plugs for source/drain regions and a side via structure, according to one or more embodiments.
FIGS. 7A-7N illustrate intermediate semiconductor devices obtained after respective steps of manufacturing the semiconductor device 300 as shown in FIG. 3 which includes backside contact plugs for source/drain regions and a side via structure, according to one or more embodiments.
FIGS. 8A and 8B are a flowchart of manufacturing the semiconductor device 300 as shown in FIG. 3 which includes backside contact plugs for source/drain regions and a side via structure, according to one or more embodiments.
FIG. 9 is a schematic block diagram illustrating an electronic device including one or more semiconductor devices including backside contact plugs for source/drain regions and a side via structure, according to one or more embodiments.

### DETAILED DESCRIPTION

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upperright," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element may be a "right" element and a "left" element when a device or structure including these elements are differently oriented.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element described in the descriptions of an embodiments could be termed a 2^{nd} element in the descriptions of another element or one or more claims, and vice versa without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c.

Herein, the terms of degree including "substantially" or "about" may be used. In one or more examples, when specifying that a parameter X may be substantially the same as parameter Y, the term "substantially" may be understood as X being within 10% of Y. In one or more examples, when specifying that a parameter is about X, the term "about" may be understood as being within 10% of X. Still, when a term "same" is used to compare parameters of two or more elements, the term may cover "substantially same" parameters.

It will be understood that, when the term "contact" is used to describe two metal elements, for example, a metal line and a via structure, a barrier metal layer such as titanium (Ti), tantalum (Ta), titanium nitride (TiN), tantalum nitride (TaN), tungsten nitride (WN), nickel nitride (NiN), cobalt nitride (CoN), or platinum nitride (PtN), not being limited thereto, may be formed therebetween. Further, it will be understood that, when a metal contact structure is described as being formed on or contact a surface of a source/drain region, a silicide layer such as cobalt silicide (CoSi₂), nickel silicide (NiSi₂), titanium silicide (TiSi₂), or tungsten silicide (WSi₂), not being limited thereto, may be formed therebetween.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

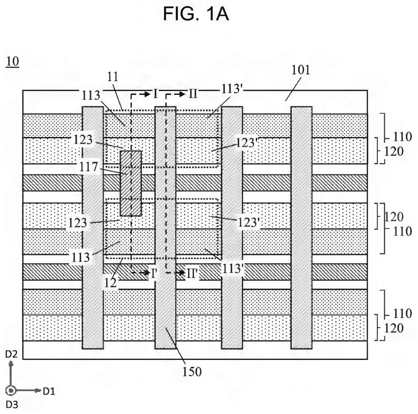

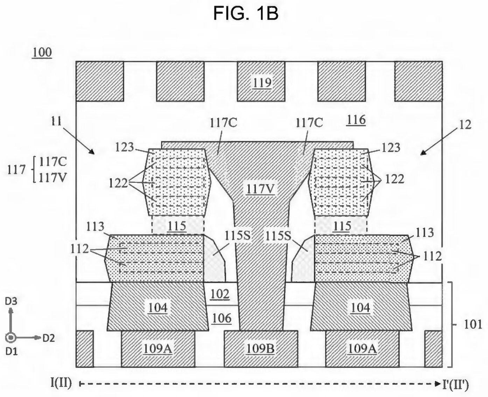

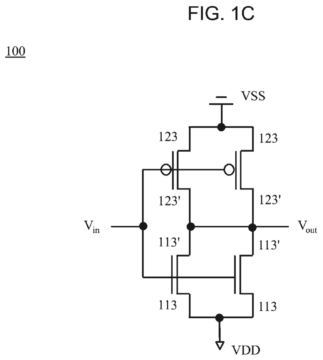

FIG. 1A illustrates is a layout of a semiconductor cell in which a semiconductor device including a side via structure and backside contact plugs for source/drain regions is formed, according to one or more embodiments, FIG. 1B is a cross-section view of the semiconductor cell taken along a line I-I' shown in FIG. 1A, according to one or more embodiments, and FIG. 1C is a schematic of an inverter circuit implemented by the stacked semiconductor device of FIGS. 1A and 1B, according to one or more embodiments.

It is to be understood that FIG. 1A shows only selected elements of a front side of a semiconductor device such as active patterns including source/drain regions, gate structures and a side via structure, and thus, some structural elements such as metal lines and contact plugs formed vertically above or below of the active patterns are not shown therein for brevity purposes. Further, in order to assist better understanding of the stacked semiconductor devices, FIG. 1B also shows some structural elements (e.g., channel structures) of the stacked semiconductor devices that can be seen at a cross-section view taken along line II-II' using dashed lines.

Referring to FIG. 1A, a semiconductor cell 10 may include a plurality of 1^{st} active patterns 110 and 2^{nd} active patterns 120 extending in a D1 direction and arranged in a D2 direction intersecting the D1 direction. The 2^{nd} active patterns 120 may be stacked on the 1^{st} active patterns 110 in a D3 direction intersecting the D1 direction and the D2 direction, and partially overlap the 1^{st} active patterns 110 in the D3 direction, respectively. Thus, a 1^{st} active pattern 110 partially overlapped by a 2^{nd} active pattern 120 may have a greater width in the D2 direction than the 2^{nd} active pattern 120. The semiconductor cell 10 may also be formed of a plurality of gate structures 150 arranged in the D1 direction and extending in the D2 direction across the active patterns 110 and 120. The semiconductor cell 10 shown in FIG. 1A may include a plurality of stacked semiconductor devices, a plurality of different types of active device, and a plurality of passive devices, not being limited thereto.

The D1 direction refers to a channel-length direction in which a current flows between two source/drain regions connected to each other through a channel structure, the D2 direction is a channel-width direction or a cell-height direction, and the D3 direction is a channel-thickness direction. The D1 direction and the D2 direction may each be referred to as a horizontal direction and the D3 direction may be referred to as a vertical direction.

Referring to FIGS. 1A and 1B, a semiconductor device 100 included in the semiconductor cell 10 may be formed of a 1^{st} stacked semiconductor device 11 and a 2^{nd} stacked semiconductor device 12 facing each other in the D2 direction on a base layer 101. The two stacked semiconductor devices 11 and 12 may be formed at a same level in the D3 direction on the base layer 101. Also, the two stacked semiconductor devices 11 and 12 may have the same structural elements, and thus, only those of the 1^{st} stacked semiconductor device 11 may be described herebelow as necessary. The base layer 101 may include a backside isolation layer 106 which is formed by replacing a silicon (Si)-based substrate and includes a plurality of backside contact plugs and a plurality of backside metal lines to be described later. The backside isolation layer 106 may be formed of a low-k material or of silicon oxide (e.g., SiO₂), not being limited thereto.

Each of the stacked semiconductor devices 11 and 12 may be formed of a 1^{st} field-effect transistor (FET), which is an n-type field-effect transistor (NFET) at a 1^{st} level (or a lower stack), and a 2^{nd} FET, which is a p-type field-effect transistor (PFET) at a 2^{nd} level (or an upper stack) above the 1^{st} level in the D3 direction. The 1^{st} FET and the 2^{nd} FET may be formed based on one of the 1^{st} active patterns 110 and one of the 2^{nd} active patterns 120, respectively, stacked thereon in the D3 direction along with a corresponding gate structure 150. The two stacked semiconductor devices 11 and 12 may form an inverter circuit formed of four (4) FETs as shown in FIG. 1C, which will be further described later.

The 1^{st} active pattern 110 for the 1^{st} FET may form a 1^{st} channel structure 112 and 1^{st} source/drain regions 113 at the 1^{st} level. The 1^{st} channel structure 112 may include a plurality of 1^{st} nanosheet layers epitaxially grown from the silicon-based substrate therebelow, and thus, the 1^{st} nanosheet layers may also be formed of silicon (Si). The 1^{st} source/drain regions 113 of n-type may be epitaxially grown from the 1^{st} nanosheet layers of the 1^{st} channel structure 112, and may be formed of silicon doped with n-type impurities (e.g., phosphorus (P), arsenic (As), or antimony (Sb)). The 1^{st} channel structure 112 may be surrounded by a gate structure 150 which controls current flow between the 1^{st} source/drain regions 113 through the 1^{st} channel structure 112. The gate structure 150 may include a gate dielectric layer surrounding the 1^{st} nanosheet layers, a 1^{st} work-function metal layer formed on the gate dielectric layer, and a gate electrode formed on the 1^{st} work-function metal layer. Thus, the 1^{st} channel structure 112 including the 1^{st} nanosheet layers, the 1^{st} source/drain regions 113 and the gate structure 150 may form the 1^{st} FET as an NFET implemented by a nanosheet transistor at the 1^{st} level.

The 2^{nd} active pattern 120 for the 2^{nd} FET may form a 2^{nd} channel structure 122 and 2^{nd} source/drain regions 123 at the 2^{nd} level. The 2^{nd} channel structure 122 may include a plurality of 2^{nd} nanosheet layers also epitaxially grown from the silicon-based substrate, and thus, the 2^{nd} nanosheet layers may also be formed of silicon. The 2^{nd} source/drain regions 123 may be epitaxially grown from the 2^{nd} nanosheet layers of the 2^{nd} channel structure 122, and may be formed of silicon germanium (SiGe) doped with p-type impurities (e.g., boron (B), gallium (Ga), or indium (In)). The 2^{nd} channel structure 122 may also be surrounded by the gate structure 150 which controls current flow between the 2^{nd} source/drain regions 123 through the 2^{nd} channel structure 122. The gate dielectric layer surrounding the 1^{st} channel structure 112 may extend to also surround the 2^{nd} channel structure 122, and a 2^{nd} work-function metal layer may be formed on this gate dielectric layer, and further, the gate electrode on the 2^{nd} work-function metal layer may also extend to surround the 2^{nd} work-function metal layer. Thus, the 2^{nd} channel structure 122 including the 2^{nd} nanosheet layers, the 2^{nd} source/drain regions 123 and the gate structure 150 may form the 2^{nd} FET as a PFET implemented by a nanosheet transistor at the 2^{nd} level.

As described earlier, the 2^{nd} active pattern 120 has a smaller width in the D2 direction than the 1^{st} active pattern 110. Accordingly, the 2^{nd} nanosheet layers forming the 2^{nd} channel structure 122 of the 2^{nd} FET may have a smaller width in the D2 direction than the 1^{st} nanosheet layers forming the 1^{st} channel structure 112 of the 1^{st} FET, and the 2^{nd} channel structure 122 may only partially overlap the 1^{st} channel structure 112 in the D3 direction.

For example, in the stacked semiconductor device 11, right side surfaces of the 2^{nd} nanosheet layers may be aligned or coplanar with right side surfaces of the 1^{st} nanosheet layers in the D3 direction, while left side surfaces of the 2^{nd} nanosheet layers are not aligned or coplanar with left side surfaces of the 1^{st} nanosheet layers in the D3 direction. In contrast, in the stacked semiconductor device 12, left side surfaces of the 2^{nd} nanosheet layers of the 2^{nd} FET may be aligned or coplanar with right side surfaces of the 1^{st} nanosheet layers of the 1^{st} FET in the D3 direction, while right side surfaces of the 2^{nd} nanosheet layers are not aligned or coplanar with right side surfaces of the 1^{st} nanosheet layers in the D3 direction. Thus, the 2^{nd} source/drain regions 123 epitaxially grown from the 2^{nd} nanosheet layers may also be formed to have a smaller width in the D2 direction than the 1^{st} source/drain regions 113 epitaxially grown from the 1^{st} nanosheet layers. Further, in the stacked semiconductor device 11, the left side surface of a 1^{st} source/drain region 113 may not be overlapped by the 2^{nd} source/drain region 123, while, in the stacked semiconductor device 12, the right side surface of a 1^{st} source/drain region 113 may not be overlapped by the 2^{nd} source/drain region 123. This width difference of the source/drain regions provides a free space above a top surface of each of the 1^{st} source/drain regions 113 which is not vertically overlapped by the 2^{nd} source/drain region 123 so that other circuit elements such as a source/drain contact plug may be formed through this space to contact at least a portion of the top surface of the 1^{st} source/drain region 113.

The foregoing characteristics of the channel structures and the source/drain regions may be provided to address increasing demands for a high device density in a semiconductor device including stacked semiconductor devices.

In each of the stacked semiconductor devices 11 and 12, the 2^{nd} channel structure 122 forming the 2^{nd} FET may have a greater number of nanosheet layers than that of the 1^{st} channel structure 112 forming the 1^{st} FET such that the two FETs may have the same or substantially same effective channel width (W_{eff}). For example, the 2^{nd} channel structure 122 may have three nanosheet layers while the 1^{st} channel structure 112 have two nanosheet layers.

The different channel widths and the different number of nanosheet layers, that is, channel layers, may facilitate optimization of the stacked semiconductor devices in the semiconductor cell 10 in terms of not only area gain for a high-density semiconductor device but also device performance such as current speed, work load distribution, power efficiency, contact resistance, thermal control, structural stability, etc.

The 1^{st} channel structure 112 and the 2^{nd} channel structure 122 may be isolated from each other through a middle isolation layer 115 which may be formed of an isolation or insulation material such as SiBCN, SiCN, SiOC, SiOCN, Si₃N₄, etc. Further, in the stacked semiconductor device 11, a side spacer 115S may be disposed on a right side surface of the 1^{st} source/drain region 113 as a residual structure of the middle isolation layer 115 which remains after the middle isolation layer 115 replaces a middle sacrificial layer formed between the two channel structures 112 and 122 during the formation of the 1^{st} stacked semiconductor device 11. In contrast, in the stacked semiconductor device 12, a side spacer 115S may be disposed on a left side surface of the 1^{st} source/drain region 113 as a residual structure of the middle isolation layer 115 which remains after the middle isolation layer 115 replaces a middle sacrificial layer formed between the two channel structures 112 and 122 during the formation of the 2^{nd} stacked semiconductor device 12.

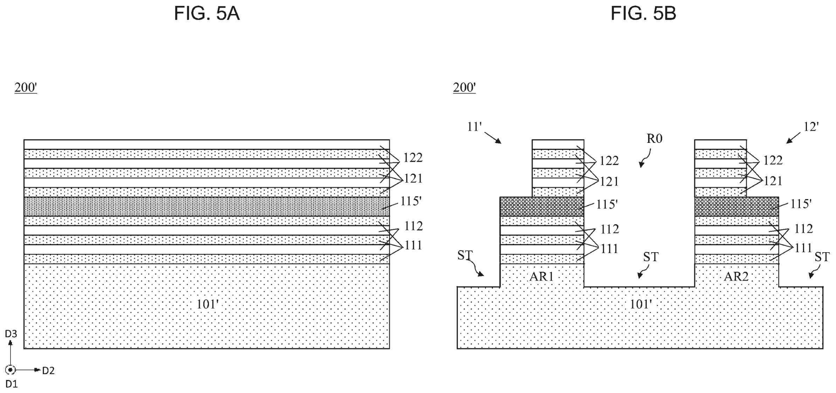

The side spacer 115S may be formed only on the right side surface among the two side surfaces of the 1^{st} source/drain region 113 in the 1^{st} stacked semiconductor device 11 because of the width difference between the two active patterns 110 and 120. In contrast, in the stacked semiconductor device 12, the side spacer 115S may be disposed only on the left side surface among the two side surfaces of the 1^{st} source/drain region 113. The formation of the side spacers 115S will be described later in reference to FIGS. 5A-5N.

A frontside isolation layer 116 may be formed a front side of the semiconductor device 100 to isolate the stacked semiconductor devices 11 and 12 from each other and from other semiconductor devices. The frontside isolation layer 116, like the backside isolation layer 106, may be formed of a low-k dielectric material such as silicon oxide (e.g., SiO₂), not being limited thereto.

On a back side of the semiconductor device 100 may be formed a BSPDN structure including backside contact plugs 104 and backside metal lines 109A and 109B. The backside contact plug 104 may be formed on a bottom surface of the 1^{st} source/drain region 113 of each of the stacked semiconductor devices 11 and 12, and may be connected to the backside metal line 109A buried in a backside isolation layer 106. The backside contact plug 104 may connect the 1^{st} source/drain region 113, which is of n-type, to a negative voltage source (VSS or ground) through the backside metal line 109A. Thus, the 1^{st} source/drain region 113 of each of the stacked semiconductor devices 11 and 12 may be powered by the negative voltage source. The backside contact plug 104 may take a form of a pillar as a via structure vertically connecting, for example, two metal lines extending in the D1 direction or D2 direction at different vertical levels in the D3 direction. In contrast, the backside metal line 109 may extend in the D1 direction beyond a length of the 1^{st} source/drain region 113 in the D1 direction.

An upper portion of the backside contact plug 104 may be disposed between shallow trench isolation (STI) structures 102 which isolate the stacked semiconductor devices 11 and 12 from each other and from other semiconductor devices in the semiconductor cell 10 or outside the semiconductor cell 10. The STI structures 102 may be formed of a low-k dielectric material such as silicon oxide (e.g., SiO₂). not being limited thereto.

While the 1^{st} source/drain regions 113 may be connected to the negative voltage source through the backside contact plugs 104 and the backside metal lines 109A as described above, the 2^{nd} source/drain regions 123 may be connected a positive voltage source (VDD) through a side via structure 117 formed in the frontside isolation layer 116 and on the backside metal line 109B isolated from the backside metal lines 109A in the backside isolation layer 106.

The side via structure 117 may have a "T" shape formed of wing portions (or contact portions) 117C respectively connected to side surfaces of the 2^{nd} source/drain regions 123 facing each other and a via portion 117V vertically extending down through the frontside isolation layer 116, the STI structure 102 and the backside isolation layer 106 between the two stacked semiconductor devices 11 and 12 to be connected to a top surface of the backside metal line 109B. Each of the wing portions 117C of the side via structure 117 may also be connected at least a portion of a top surface of each of the 2^{nd} source/drain regions 123. The side via structure 117 may also be referred to as a via power rail (VPR). The side via structure 117 may be a single continuum structure formed through a single deposition operation in a process of manufacturing the semiconductor device 100, and thus, there may be no connection surface, interface or junction between the wing portion 117C connected to each of the 2^{nd} source/drain regions 123 and the via portion 117V connected to the backside metal line 109B when viewed in, for example, scanning electron microscopy (SEM) or transmission electron microscopy (TEM).

Above the stacked semiconductor devices 11 and 12 may be formed a plurality of frontside metal lines 119 provided to connect other circuit elements of semiconductor devices including the stacked semiconductor devices 11 and 12 in the semiconductor cell 10 to the positive voltage source, the negative voltage source, or other circuit elements in the semiconductor cell 10 or outside thereof.

The backside contact plugs 104, the side via structure 117 and the metal lines 109A, 109B and 119 may be formed of the same metal or metal alloy or different metal or metal alloys, which may be, for example, tungsten (W), copper (Cu), aluminum (Al), molybdenum (Mo), ruthenium (Ru), etc., or an alloy thereof.

As the stacked semiconductor devices 11 and 12 form an inverter circuit of which the circuit schematic is shown in FIG. 1C, the 1^{st} source/drain regions 113 shown in FIG. 1B are both connected to the negative voltage source and the 2^{nd} source/drain regions 123 shown in FIG. 1B are both connected to the positive voltage source. In contrast, the other 1^{st} source/drain regions 113' shown in FIG. 1B connected to the 1^{st} channel structures 112 and the other 2^{nd} source/drain regions 123' shown in FIG. 1B connected to the 2^{nd} channel structures 122 are all connected to each other through the frontside metal lines 119 and an overlying metal line to form a common output of the inverter circuit.

Due to the side via structure 117 and the BSPDN structure including the backside contact plugs 104 and the backside metal lines 109A and 109B, not only the 1^{st} source/drain regions 113 of the 1^{st} FETs at the 1^{st} level but also the 2^{nd} source/drain regions 123 of the 2^{nd} FETs at the 2^{nd} level may be connected to the voltage source through the back side of the stacked semiconductor device 100 in the semiconductor cell 10. Thus, the semiconductor cell 10 may avoid a heavy traffic of signal lines and power rails and increased contact resistance between structural elements at the front side of the semiconductor devices including the stacked semiconductor devices 11 and 12.

Further, the stacked semiconductor devices 11 and 12 are formed to be symmetrical to each other along the D2 direction with respect to the side via structure 117 such that the upper portion of the side via structure 117 is connected to the right surface of the 2^{nd} source/drain region 123 vertically overlapping the right side surface of the 1^{st} source/drain pattern 113 with the side spacer 115S thereon in the 1^{st} stacked semiconductor device 11 and the left side surface of the 2^{nd} source/drain region 123 vertically overlapping the left side surface of the 1^{st} source/drain pattern 113 with the side spacer 115S thereon in the 2^{nd} stacked semiconductor device 12. This symmetrical formation of the stacked semiconductor devices 11 and 12 may be performed to shorten a length of the upper portion of the side via structure 117 in the D2 direction to reduce a cell height of the semiconductor cell 10.

However, as demand for a scaled-down semiconductor cell increases, formation of stacked semiconductor devices such as the stacked semiconductor devices 11 and 12 becomes more challenging. This is at least because, while spacing between two adjacent stacked semiconductor devices in the D2 direction needs to be further reduced, formation of the side via structure 117 having a high aspect ratio has a very small process margin. As shown in FIG. 1B, the side via structure 117 is required to be formed to extend down further to contact the top surface of the metal line 109B through the frontside isolation layer 116, the STI structure 102 and the backside isolation layer 106. Thus, a risk of misalignment between the side via structure 117 and the backside metal line 109B may increase in the process of manufacturing the semiconductor device 100.

Thus, the following embodiments address the difficulty in formation of the side via structure 117 of the stacked semiconductor devices 11 and 12.

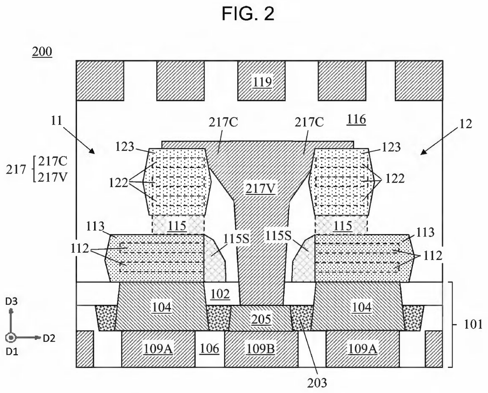

FIG. 2 illustrates a semiconductor devices including backside contact plugs for source/drain regions and a side via structure, according to one or more embodiments.

Referring to FIG. 2, which corresponds to FIG. 1B, a semiconductor device 200 may include the same structural elements of the semiconductor device 100, and thus, duplicate descriptions thereof may be omitted herein and the same reference numerals or characters used to indicate these structural elements of the semiconductor device 100 may be used herebelow to describe the semiconductor device 200.

However, the semiconductor device 200 may include a different side via structure 217 and further include a backside contact plug 205 on the side via structure 217, surrounded by deep trench isolation structures 203. The side via structure 217 may have a smaller height than the side via structure 117 of the semiconductor device 100 at least because the side via structure 217 does not extend down into the backside isolation layer 106 to be connected to the backside metal line 109B. Instead, the backside contact plug 205 may connect the side via structure 217 to the backside metal line 109B, thereby enabling formation of the smaller-height side via structure 217. The deep trench isolation structures 203 may surround a side surface of the backside contact plug 205 and at least a lower portion of each of the backside contact plugs 104.

The deep trench isolation structures 203 may be formed of an isolation or insulation material such as silicon nitride (e.g., Si₃N₄), not being limited thereto. Alternatively, the deep trench isolation structures 203 may be formed of aluminum oxide (e.g., Al₂O₃). The backside contact plug 205 connected to a bottom surface of the side via structure 217 may be formed of a metal or a metal alloy which may be the same as or different from that forming the side via structure 217. As will be described later in reference to FIGS. 5A-5N, the side via structure 217 and the backside contact plug 205 thereon may be formed at different steps, and thus, the bottom surface of the side via structure 217 and a top surface of the backside contact plug 205 may form a connection surface, an interface or a junction therebetween when viewed in, for example, SEM or TEM even if the two structures may be formed of the same metal or metal alloy. The deep trench isolation structures 203 may be used to form the backside contact plugs 104 and 205, and may remain when the semiconductor device 200 is completed.

Two adjacent deep trench isolation structures 203 among the plurality of deep trench isolation structures 203 surrounding the backside contact plug 205 may be on two opposite side surfaces of the backside contact plug 205, and each of these two deep trench isolation structures 203 surrounding the backside contact plug 205 may also be on a lower side surface of the backside contact plug 104 formed on a bottom surface of the 1^{st} source/drain region 113 of each of the stacked semiconductor devices 11 and 12. Another deep trench isolation structure 203 may be formed on an opposite lower side surface of the backside contact plug 104. Bottom surfaces of the deep trench isolation structure 203 may be at the same level of bottom surfaces of the backside contact plugs 104 and 205. Top surfaces of the deep trench isolation structures 203 may be at the same level as bottom surfaces of the STI structures 102 and a top surface of the backside isolation layer 106.

Top surfaces of the deep trench isolation structures 203 for the backside contact plugs 104 and 205 may be connected to bottom surfaces of the STI structures 102, respectively, and bottom surfaces of the deep trench isolation structures 203 may be buried in the backside isolation layer 106 and may be connected to a portion of the backside metal line 109B.

As the backside contact plug 205 surrounded by the deep trench isolation structures 203 is formed in the semiconductor device 200, the aspect ratio of the side via structure 217 may be reduced, compared to the side via structure 117 of the semiconductor device 100, to facilitate formation of the side via structure 217 through the frontside isolation layer 116 and the STI structure 102. For example, as the height of the side via structure 217 of the semiconductor device 200 is smaller than that of the side via structure 117 of the semiconductor device 100, the process margin for forming the side via structure 217 may increase, and thus, a risk of misalignment between the side via structure 217 and the backside metal line 109B may be reduced due to the backside contact plug 205 in a process of manufacturing the semiconductor device 200.

As described above, the semiconductor device 200 may be characterized by the backside contact plugs 104 and 205 and the deep trench isolation structure 203 used to form these backside contact plugs 104 and 205 and remain in a completed form of the semiconductor device 200. However, the backside contact plug 205 may be differently formed in manufacturing a semiconductor device including stacked semiconductor devices.

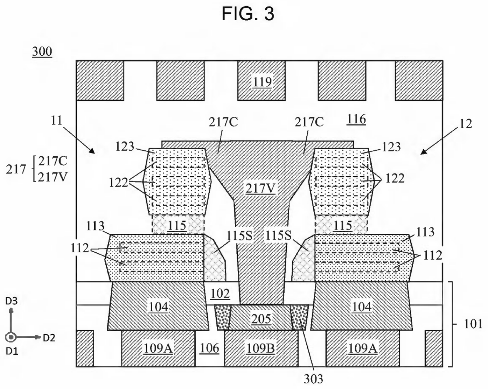

FIG. 3 illustrates a semiconductor devices including backside contact plugs for source/drain regions and a side via structure, according to one or more other embodiments.

Referring to FIG. 3, which corresponds to FIG. 2, a semiconductor device 300 may include the same structural elements of the semiconductor device 200, and thus, duplicate descriptions thereof may be omitted herein and the same reference numerals or characters used to indicate these structural elements of the semiconductor device 200 may be used herebelow to describe the semiconductor device 300.

However, the semiconductor device 300 may differ from the semiconductor device 200 in that two deep trench isolation structures 303 may surround two opposite side surfaces of only the backside contact plug 205 on the side via structure 217, while the deep trench isolation structures 203 of the semiconductor device 200 surrounds at least the lower portion of each of the backside contact plugs 104 as well as the backside contact plug 205. Thus, in the semiconductor device 300, no deep trench isolation structures may be formed on side surfaces of the backside contact plugs 104 respectively connected to bottom surfaces of the 1^{st} source/drain regions 113. Instead, the backside isolation layer 106 may be on lower side surfaces of the backside contact plugs 104 while the STI structures 102 may be on upper side surfaces of the backside contact plugs 104. Still, bottom surfaces of the deep trench isolation structures 303 may be at the same level of the bottom surface of the backside contact plug 205, and top side surfaces of the deep trench isolation structures 303 may be at the same level as top surfaces of the backside contact plug 205 and the bottom surfaces of the STI structures 102.

This deep trench isolation structure 303 may be formed of the same isolation or insulation material forming the deep trench isolation structure 203. The deep trench isolation structure 303 may be used to form only the backside contact plug 205 on the side via structure 217 and remain in the semiconductor device 300 when the semiconductor device 300 is completed, while, in the semiconductor device 200, the deep trench isolation structures 203 may be used to form the backside contact plugs 104 on the 1^{st} source/drain regions 113 as well as the backside contact plug 205 on the side via structure 217 and remain when the semiconductor device 200 is completed.

In the meantime, the side via structures 117 and 217 formed in the semiconductor devices 100, 200 and 300 of the above embodiments is formed as a single continuum structure having no connection surface, interface or junction between the wing portions and the via portion as described above. However, the disclosure is not limited thereto as shown in FIG. 3.

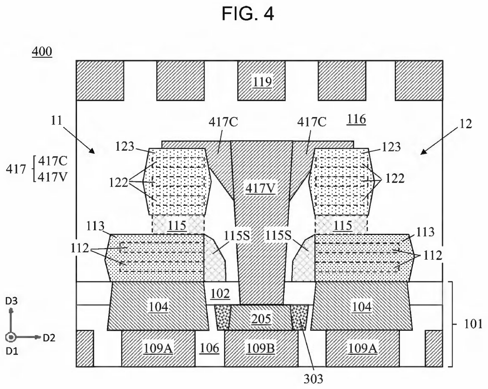

FIG. 4 illustrates a semiconductor devices including backside contact plugs for source/drain regions and a side via structure, according to still one or more other embodiments.

Referring to FIG. 4, which corresponds to FIG. 3, a semiconductor device 400 may include the same structural elements of the semiconductor device 300, and thus, duplicate descriptions thereof may be omitted herein and the same reference numerals or characters used to indicate these structural elements of the semiconductor device 300 may be used herebelow to describe the semiconductor device 400.

However, the semiconductor device 400 may differ from the semiconductor device 300 in that a side via structure 417 is formed of three distinct structural elements, two frontside contact structures 417C and a via structure 417V. The frontside contact structures 417C may be respectively connected to the right side surface of the 2^{nd} source/drain region 123 of the 1^{st} stacked semiconductor device 11 and the left side surface of the 2^{nd} source/drain region 123 of the 2^{nd} stacked semiconductor device 12, and the via structure 417V may be connected to the backside metal line 109B through the backside contact plug 205 thereon.

The frontside contact structures 417C and the via structure 417V of the semiconductor device 400 may correspond to the wing portions 217C and the via portion 217V of the side via structures 217 of the semiconductor device 300, respectively. The via structure 417V may be formed at a different step from a step of forming the frontside contact structures 417C, and thus, a connection surface, an interface or a junction may be formed therebetween, when viewed in, for example, SEM or TEM, even if these structures may be formed of the same metal or metal alloy.

Provided herebelow is a method of manufacturing a semiconductor device including backside contact plugs for source/drain regions and a side via structure, according to one or more embodiments.

FIGS. 5A-5N illustrate intermediate semiconductor devices obtained after respective steps of manufacturing the semiconductor device 200 as shown in FIG. 2 which includes backside contact plugs for source/drain regions and a side via structure, according to one or more embodiments. Herebelow, duplicate descriptions, including those about materials and structures, thereof may be omitted and the same reference numbers may be used in the descriptions herebelow.

Referring to FIG. 5A, an intermediate semiconductor device 200' may be formed by epitaxially growing a plurality of semiconductor layers (nanosheet layers) on a substrate 101'.

The semiconductor layers may be epitaxially grown from the substrate 101' in the order of a lower stack including 1^{st} sacrificial layers 111 and 1^{st} channel layers 112 vertically stacked in an alternating manner, a middle sacrificial layer 115', and an upper stack including 2^{nd} sacrificial layers 121 and 2^{nd} channel layers 122 vertically stacked in an alternating manner on the middle sacrificial layer 115'. The 1^{st} channel layers 112 and the 2^{nd} channel layers 122 described herein in reference to FIGS. 5A-5N may refer to the 1^{st} channel structure 112 and the 2^{nd} channel structure 122 described in reference to FIGS. 2-4.

While the substrate 101' and the channel layers 112 and 122 are formed of silicon (Si), the sacrificial layers 111, 115' and 121 may be formed of silicon germanium (SiGe) with respective Ge concentrations therein. The middle sacrificial layer 115' may have a higher Ge concentration than the 1^{st} and 2^{nd} sacrificial layers 111 and 121. For example, the middle sacrificial layer 115' may have a Ge concentration of 40-45%, and the 1^{st} and 2^{nd} sacrificial layers 111 and 121 may have a Ge concentration of 25-30%.

Here, the sacrificial layers 111, 115' and 121 are referred to as such because these layers will be removed and replaced by other layers or structures in later steps of manufacturing a semiconductor device from the intermediate semiconductor device 200'

Referring to FIG. 5B, the intermediate semiconductor device 200' may be patterned to obtain a 1^{st} semiconductor stack 11' and a 2^{nd} semiconductor stack 12' facing each other on the substrate 101', and also, the substrate 101' may be patterned to form a shallow trenches ST thereon.

The patterning of the intermediate semiconductor device 200' into the two semiconductor stacks 11' and 12' may be performed such that an upper stack of each of the two semiconductor stacks 11' and 12' has a smaller width than a lower stack thereof with a middle sacrificial layer 115' thereon, and the two semiconductor stacks 11' and 12' face each other in the D2 direction with a 1^{st} recess R0 therebetween. For example, the patterning may be performed such that the lower stack is partially overlapped in the D3 direction. Further, the patterning may be performed such that a right side surface of the 1^{st} semiconductor stack 11' formed by right side surfaces of the lower stack, the middle sacrificial layer 115', and the upper stack thereof, which are vertically aligned or coplanar with each other, faces a left side surface of the 2^{nd} semiconductor stack 12' formed by left side surfaces of the lower stack, the middle sacrificial layer 115', the upper stack thereof, which are vertically aligned or coplanar with each other. Here, the lower stack and the upper stack of each of the semiconductor stacks 11' and 12' may refer to the 1^{st} active pattern 210 and the 2^{nd} active pattern 220 shown in FIG. 1A, respectively.

Further, the patterning of the substrate 101' may form a plurality of shallow trenches ST in the substrate at positions not overlapped by the two semiconductor stacks 11' and 12'. For example, the shallow trenches ST may be formed on the substrate 101' at a left side of the 1^{st} semiconductor stack 11', a right side of the 2^{nd} semiconductor stack 12', and between the 1^{st} semiconductor stack 11' and the 2^{nd} semiconductor stack 12'. Portions of the substrate 101' having a protrusion form between the shallow trenches ST may be referred to as active regions which may be doped with impurities or dopants. A 1^{st} active region AR1 and a 2^{nd} active region AR2 may be formed on the substrate 101' for the 1^{st} semiconductor stack 11' and the 2^{nd} semiconductor stack 12', respectively. The patterning of the intermediate semiconductor device 200' and the substrate 101' in this step may be performed through, for example, drying etching (e.g., reactive ion etching (RIE)) based on a dummy gate structure with hard mask patterns thereon.

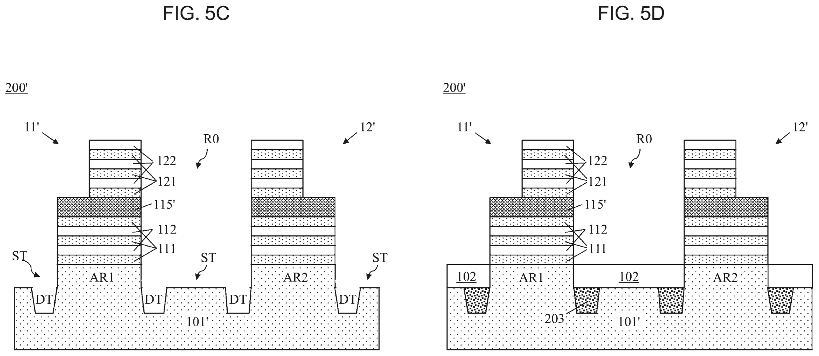

Referring to FIG. 5C, a plurality of deep trenches DT may be formed in the substrate 101' at sides of the active regions AR1 and AR2 in the shallow trenches ST.

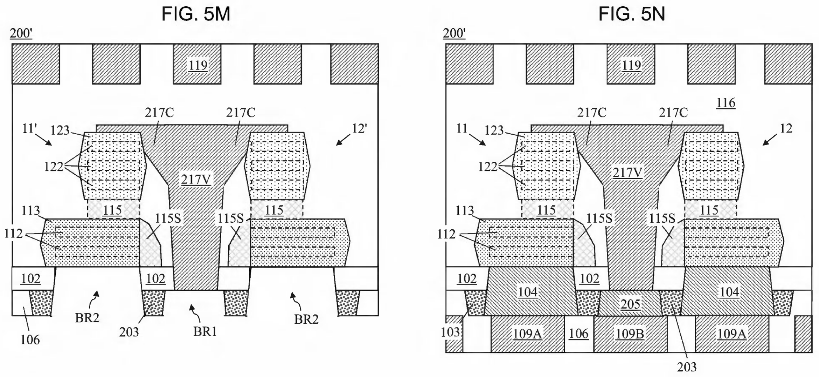

For example, the deep trenches DT may be formed by patterning portions of the substrate 101' from top at positions between which backside contact plugs for source/drain regions and a side via structure are to be formed in a later step (FIG. 5N).

To form the deep trenches DT, another drying etching operation (e.g., RIE) following the formation of the shallow trenches ST may be performed using additional hard mask patterns on the substrate 101'.

Referring to FIG. 5D, a plurality of deep trench isolation structures 203 may be formed in the respective deep trenches DT and shallow trench isolation (STI) structures 102 may be formed in the shallow trenches ST.

The deep trench isolation structures 203 may be formed through, for example, depositing silicon nitride (e.g., Si₃N₄) or aluminum oxide (e.g., AL₂O₃) in the deep trenches DT using chemical vapor deposition (CVD), plasma enhanced chemical vapor deposition (PECVD), physical vapor deposition (PVD), an atomic layer deposition (ALD), or a combination thereof, followed by planarization using, for example, a chemical-mechanical polishing (CMP) operation. Subsequently, the STI structures 102 may be formed on the substrate 101' with the deep trench isolation structures 203 therein in the shallow trenches ST through, for example, depositing silicon oxide (e.g. SiO₂) using CVD, PVD, PECVD or a combination thereof, followed by planarization using, for example, a CMP operation. Thus, bottom surfaces of the STI structures 102 may be on or contact top surfaces of the substrate 101' and the deep trench isolation structures 203.

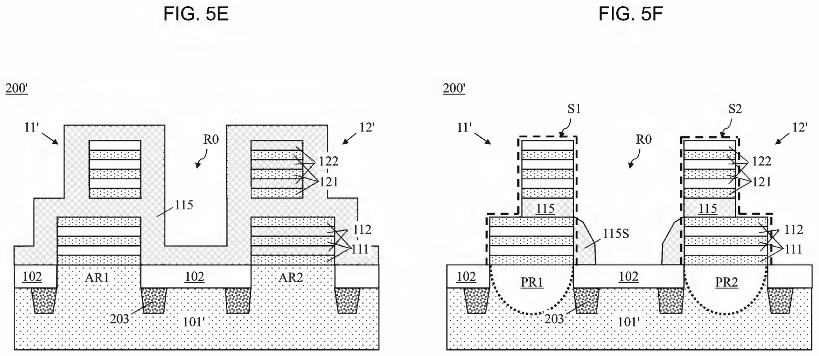

Referring to FIG. 5E, the middle sacrificial layer 115' may be removed and replaced by a middle isolation layer 115 surrounding the lower stack and the upper stack of each of the semiconductor stacks 11' and 12'.

The removal of the middle sacrificial layer 115' may be performed through, for example, wet etching using an etchant such as an ammonia-peroxide mixture which removes the middle sacrificial layer 115' of SiGe with a high Ge concentration while the channel layers 112 and 122 of silicon (Si) and the sacrificial layers 111 and 121 of SiGe with a low Ge concentration are not or minimally attacked by the etchant.

Further, an isolation material such as SiBCN, SiCN, SiOC, SiOCN, SiN, Si₃N₄, etc., may fill in a space from which the middle sacrificial layer 115' is removed, thereby forming a middle isolation layer 115. The formation of the middle isolation layer 115 may be performed through, for example, ALD or PEALD. At this time, the middle isolation layer 115 may be spread to conformally surround the outer profile of both the lower and upper stacks of each of the semiconductor stacks 11' and 12' as well as the top surfaces of the STI structures 102.

The middle isolation layer 115 may be formed to isolate a channel structure to be formed from the lower stack and a channel structure to be formed from the upper stack in each of the semiconductor stack 11' and 12'.

Referring to FIG. 5F, each of the 1^{st} semiconductor stack 11' and the 2^{nd} semiconductor stack 12' may be patterned to form spaces S1, S2 where a lower source/drain region and an upper source/drain region thereabove are to be formed, and further, the substrate 101' exposed by the patterning of the semiconductor stacks 11' and 12' may be patterned to form placeholder recesses PR1 and PR2 therein. At this time, the middle isolation layer 115 may also be patterned to remain only between the lower stack and the upper stack of each of the semiconductor stacks 11' and 12' and at side surfaces of the lower stacks facing each other in the D2 direction as side spacers 115S.

The upper stack and the lower stack, that is, the 2^{nd} active pattern 120 and the 1^{st} active pattern 110 therebelow (FIG. 1A), of each of the semiconductor stacks 11' and 12' may be patterned through, for example, dry etching or wet etching between the dummy gate structures 150 as shown in FIG. 1A to form therein spaces S1 and S2 where source/drain regions for the 1^{st} semiconductor stack 11' and the 2^{nd} semiconductor stack 12' are to be formed in a later step.

When the upper stack and the lower stack are patterned to form the spaces S1 and S2, the middle isolation layer 115 surrounding the outer profile of the upper stack and the lower stack may also be patterned from top. Thus, the middle isolation layer 115 may be removed from top, left side and right side surfaces of the upper stack, a top surface of the lower stack not vertically overlapped by the upper stack, a left side surface of the lower stack and top surfaces of the STI structures 102. At this time, however, the middle isolation layer 115 may remain at a space between the upper stack and the lower stack without being patterned to isolate two channel structures to be formed from the upper stack and the lower stack in a later step. Further, the middle isolation layer 115 may also remain as a side spacer 115S at a side surface of the lower stack vertically aligned or coplanar with a side surface of the upper stack thereabove.

In the 1^{st} semiconductor stack 11', the middle isolation layer 115 may remain as the side spacer 115S at a right side surface of the lower stack vertically aligned or coplanar with a right side surface of the upper stack although an upper portion thereof may be partially removed. This residual structure of the middle isolation layer 115 may remain on the right side surface of the lower stack due to the different widths of the lower stack and the upper stack in the D2 direction and the aligned, coplanar side surfaces of the right side surfaces of the upper stack and the lower stack.

For example, when the space S1 for the upper source/drain region and the lower source/drain region is formed, the middle isolation layer 115 formed at the left side surface and the middle isolation layer 115 formed at the right side surface of the upper stack may be removed at the same time because these two portions of the middle isolation layer 115 have the same vertical length from the top surface. At this time, the middle isolation layer 115 formed at the left side surface of the lower stack may also be removed. This is because the left side surface of the lower stack is not overlapped by the upper stack, and thus, subjected to the patterning of the middle isolation layer 115 at the side surfaces of the upper stack at the same time. Moreover, the middle isolation layer 115 formed at the left side surface of the lower stack has a smaller vertical length than that formed at the side surfaces of the upper stack. Thus, the middle isolation layer 115 at the left side surface of the lower stack may be patterned earlier than the middle isolation layer 115 at the side surface of the upper stack when subjected to the same patterning at the same time.

When the middle isolation layer 115 is removed from the side surfaces of the upper stack, the middle isolation layer 115 formed at the top surface of the upper stack, the top surface of the lower stack not overlapped by the upper stack, and the top surface of the STI structures 202 may also be removed. This is because these portions of the middle isolation layer 115 are subjected to the same patterning of the middle isolation layer 115 at the side surfaces of the upper stack at the same time, and have a smaller vertical length than the middle isolation layer 115 at the side surfaces of the upper stack.

Thus, when the middle isolation layer 115 is removed from the top, left side and right side surfaces of the upper stack, the top surface of the lower stack not vertically overlapped by the upper stack, the left side surface of the lower stack and the top surfaces of the STI structures 102, the middle isolation layer 115 may still remain at the right side surface of the lower stack as the side spacer 115S.

For the same reasons described above, the middle isolation layer 115 formed in the 2^{nd} semiconductor stack 12' may remain in a space between the lower stack and the upper stack and at the left side surface of the lower stack as a side spacer 115S.

Subsequent to the patterning of the upper stack and the lower stack along with the middle isolation layer 115, the substrate 101' exposed below the space S1 and S2 formed by the patterning of the lower stack and the upper stack may be patterned to form the placeholder recesses PR1 and PR2 in which respective placeholder structures are to be formed in a next step. The placeholder structures are formed in these two placeholder recesses PR1 and PR2 to reserve spaces where backside contact plug connected to bottom surfaces of source/drain regions are to be formed in a later step. The patterning operations to form the spaces S1 and S2 and the placeholder recesses PR1 and PR2 respectively therebelow may be performed through, for example, dry etching or wet etching.

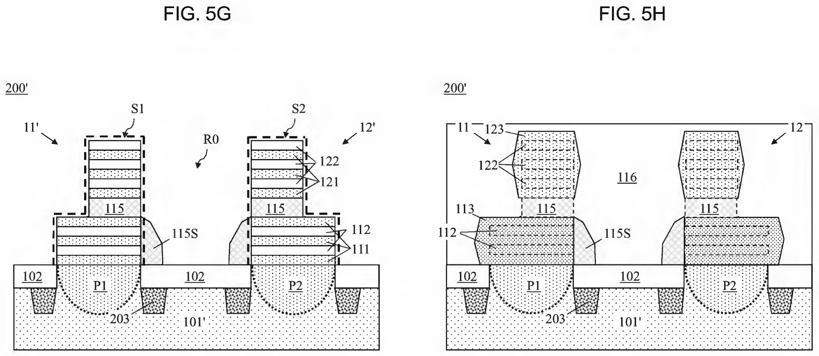

Referring to FIG. 5G, the placeholder recesses PR1 and PR2 may be filled in with placeholder structures P1 and P2, respectively.

The placeholder structures P1 and P2 may be epitaxially grown from the substrate 101' forming inner surfaces of the placeholder recesses PR1 and PR2 in the spaces S1 and S2 obtained in the previous step (FIG. 5F) such that a top surface of each of the placeholder structures P1 and P2 may be at a level of a top surface of the STI structures 102 and respective bottom surfaces of the lowermost sacrificial layer 111 and the side spacer 115S. The placeholder structures P1 and P2 may be formed of silicon germanium (SiGe).

Referring to FIG. 5H, a 1^{st} source/drain region 113 and a 2^{nd} source/drain region 123 may be formed in each of the spaces S1 and S2 obtained by the patterning of the lower stack and the upper stack in each of the semiconductor stacks 11' and 12' in the previous step (FIG. 5F), and a frontside isolation layer 116 may be formed to surround the semiconductor stacks 11' and 12', thereby forming a 1^{st} stacked semiconductor device 11 and a 2^{nd} stacked semiconductor device 12.

The 1^{st} source/drain region 113 may be epitaxially grown from the 1^{st} channel layers 112 in the spaces S1, S2 generated from the first sacrificial layers 111 are removed, and the 2^{nd} source/drain regions 123 may be epitaxially grown from the 2^{nd} channel layers 122 in the spaces S1, S2 generated from the first sacrificial layers 111 are removed. When the epitaxial growth of the source/drain regions 113 and 123 is performed, n-type impurities such as phosphorus (P), arsenic (As), antimony (Sb), etc. may be in-situ doped in the epitaxial structure for the 1^{st} source/drain regions 113, and p-type impurities such as boron (B), gallium (Ga), or indium (In), etc. may be in-situ doped in the epitaxial structure for the 2^{nd} source/drain region 123.

When the 1^{st} source/drain region 113 is grown from the 1^{st} channel layers 112 of the 1^{st} semiconductor stack 11', a right side surface of the 1^{st} source/drain region 113 may contact the side spacer 115S formed on the right side surface of the lower stack of the 1^{st} semiconductor stack 11'. In the same manner, a left side surface of the 1^{st} source/drain region 113 grown from the 1^{st} channel layers 112 of the 2^{nd} semiconductor stack 12' may contact the side spacer 115S formed on the left side surface of the lower stack of the 2^{nd} semiconductor stack 12'. Thus, an entire right side surface of one 1^{st} source/drain region 113 and an entire left side surface of the other 1^{st} source/drain region 113 may be covered by the respective side spacers 115S.

With the formation of the source/drain regions 113 and 123, the frontside isolation layer 116 may be formed to surround the semiconductor stacks 11' and 12' to isolate the semiconductor stacks 11' and 12' from each other or other circuit elements. The frontside isolation layer 116 may be formed through, for example, deposition of a low-k material such as silicon oxide (e.g. SiO₂) using CVD, PVD, PECVD, etc. As the frontside isolation layer 116 surrounds the semiconductor stacks 11' and 12', the 1^{st} recess R0 formed therebetween may also be filled in with the frontside isolation layer 116.

Subsequent to the formation of the 1^{st} frontside isolation layer 116, the dummy gate structure surrounding the semiconductor stacks 11' and 12' and the sacrificial layers 111 and 121 may be removed and replaced by respective gate structures 150 surrounding the channel layers 112 and 122.

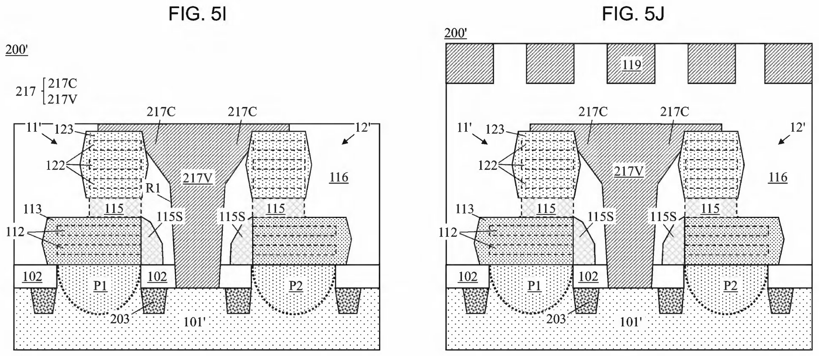

Referring to FIG. 5I, a side via structure 217 may be formed in the frontside isolation layer 116 to contact the 2^{nd} source/drain regions 123 of the semiconductor stacks 11' and 12' and extend down to contact a top surface of the substrate 101' through the STI structure 102 between the stacked semiconductor devices 11 and 12.

The side via structure 217 may be formed to connect the 2^{nd} source/drain regions 123 to a positive voltage source through a backside contact plug and a backside metal line to be formed in a later step (FIG. 5N).

To form the side via structure 217, the frontside isolation layer 116 may be patterned therein through, for example, dry etching or wet etching to form a recess R1 exposing at least a portion of a top surface and at least a portion of a side surface of each of the 2^{nd} source/drain regions 123 and a portion of the top surface of the substrate 101' between the semiconductor stacks 11' and 12'. Subsequently, the side via structure 217 may be formed in the recess R1 through, for example, depositing a metal or a metal alloy therein using CVD, PVD, PECVD or a combination thereof, followed by planarization using, for example, a CMP, operation so that the side via structure 217 may connect the at least a portion of the top surface and at least a portion of the side surface of each of the 2^{nd} source/drain regions 123 to a portion of the top surface of the substrate 101' between the semiconductor stacks 11' and 12'.

As shown in FIG. 5I, the side via structure 217 may have a "T" shape formed of wing portions 217C and a via portion 217V. Each of the wing portions 217C may be connected to at least a portion of the top surface and the at least a portion of the side surface of the 2^{nd} source/drain region 123 of each of the semiconductor stacks 11' and 12'. The via portion 217V may vertically extend down in the recess R1 from a level of a top surface of the frontside isolation layer 116 to a top surface of the substrate 101' through the STI structure 102 formed between the semiconductor stacks 11' and 12' on the substrate 101'

The wing portions 217C and the via portion 217V may be formed at a same time through a single deposition operation to form the side via structure 217, and thus, no connection surface, interface or junction may be formed between the wing portions 217C and the via portion 217V when viewed in, for example, SEM or TEM. However, the wing portions 217C may be formed at a different step from a step of forming the via portion 217V, in which case the side via structure 217 may have the same form as the side via structure 417 formed of the frontside contact structures 417C and the via structure 417V as shown in FIG. 4. In this case, a connection surface, an interface or a junction may be formed between the wing portions 217C and the via portion 217V even if these structures may be formed of the same metal or metal alloy when viewed in, for example, SEM or TEM.

Here, since an aspect ratio of the side via structure 217 may be smaller than that of the side via structure 117 which penetrates into the backside isolation layer 106 replacing the substrate 101' as shown in FIG. 1B, formation of the side via structure 217 may be more facilitated than the side via structure 117 in the frontside isolation layer 116.

Referring to FIG. 5J, an additional isolation material is formed on the top surface of the frontside isolation layer 116 to expand the frontside isolation layer 116 and a plurality of frontside metal lines 119 may be formed above the side via structure 217.

The frontside isolation layer 116 may be expanded through, for example, depositing an isolation material such as silicon oxide (e.g., SiO₂) on the top surface of the frontside isolation layer 116 using CVD, PVD, PECVD, etc., or a combination thereof, followed by planarization using, for example, a CMP operation.

In the expanded frontside isolation layer 116 may be formed the frontside metal lines 219 through, for example, a damascene process or a direct etching operation, using a metal or a metal alloy which is the same as or different from that of the side via structure 217. The frontside metal lines 219 may be provided to connect other circuit elements of the semiconductor stacks 11' and 12' to a positive voltage source, a negative voltage source, or still circuit elements of other semiconductor devices.

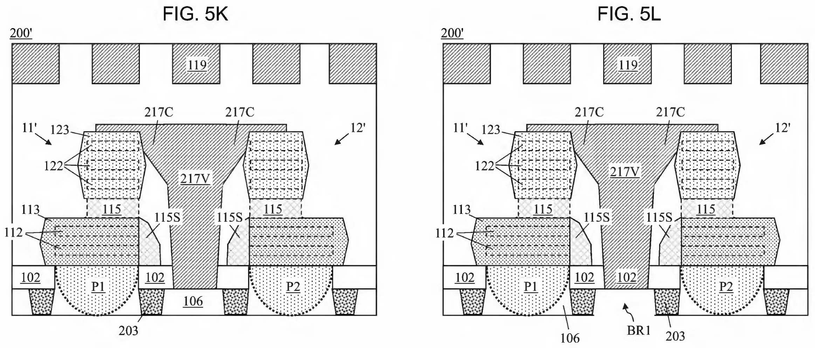

Referring to FIG. 5K, the substrate 101' may be thinned to expose the placeholder structures P1 and P2 and the deep trench isolation structures 203 and the remaining substrate 101' may be removed and replaced by a backside isolation layer 106.

The substrate 101' may be thinned through, for example, a backside thinning operation in which the substrate 101' is mechanically grinded to expose bottom surfaces of the placeholder structures P1 and P2 and the deep trench isolation structures 203, followed by dry etching or wet etching to remove the remaining substrate 101' surrounding the placeholder structures P1 and P2 and the deep trench isolation structures 203.

A space obtained by the removal of the substrate 101' may be filled in with a low-k material such as silicon oxide (e.g., SiO₂) to form the backside isolation layer 106, followed by planarization using, for example, a CMP operation to expose bottom surfaces of the placeholder structures P1 and P2 and the deep trench isolation structures 203 again.

To perform the substrate removal operation in this step and the subsequent backside operations, the intermediate semiconductor device 200' obtained in the previous step (FIG. 5J) may be turned upside down to facilitate the backside operations.

Referring to FIG. 5L, a portion of the backside isolation layer 106 vertically below the side via structure 217 may be removed based on two adjacent deep trench isolation structures 203 between the semiconductor stacks 11' and 12' to form a 1^{st} backside recess BR1 in the backside isolation layer 106 to expose a bottom surface of the side via structure 217.

The removal of the portion of the backside isolation layer 106 in this step may be performed through, for example, dry etching or wet etching of the backside isolation layer 106 at a position vertically below the side via structure 217 between two adjacent deep trench isolation structures 203 using an etchant such as hydrofluoric acid (HF) that selectively etches silicon oxide (e.g. SiO₂) forming the backside isolation layer 106 against the material (e.g., Si₃N₄ or Al₂O₃) forming the deep trench isolation structures 203.

Referring to FIG. 5M, the backside isolation layer 106 surrounding the placeholder structures P1 and P2 and the placeholder structures P1 and P2 may be removed to form 2^{nd} backside recesses BR2 to expose bottom surfaces of the 1^{st} source/drain regions 213 of the respective semiconductor stacks 11' and 12'.

Similar to the previous step (FIG. 5L), the removal of the backside isolation layer 106 may be performed through, for example, dry etching or wet etching using an etchant such as hydrofluoric acid (HF) against the material (e.g., Si₃N₄ or Al₂O₃) forming two adjacent deep trench isolation structures 203 between which the placeholder structures P1 and P2 with the backside isolation layer 106 thereon are formed. The removal of the placeholder structures P1 and P2 may be performed through, for example, dry etching or wet etching using an etchant such as an ammonia-peroxide mixture, which selectively etches the material (e.g., SiGe) forming the placeholder structures P1 and P2 against the material (e.g., Si₃N₄ or Al₂O₃) forming the deep trench isolation structures 203 and silicon oxide (e.g. SiO₂) forming the backside isolation layer 106.

Referring to FIG. 5N, the backside recesses BR1 and BR2 respectively exposing the bottom surfaces of the side via structure 217 and the 1^{st} source/drain regions 213 may be filled in with backside contact plugs 205 and 104, respectively, thereby completing a semiconductor device 200.

A metal or a metal alloy similar to or different from that of the side via structure 217 may fill in the backside recesses BR1 and BR2 through, for example, CVD, PVD, PECVD, etc. to form a backside contact plug 205 on the bottom surface of the side via structure 217 and backside contact plugs 104 on the bottom surfaces of the respective 1^{st} source/drain regions 123 of the stacked semiconductor devices 11 and 12.

Subsequently, the backside isolation layer 106 may be expanded through, for example, depositing an isolation material such as silicon oxide (e.g., SiO₂) on bottom surfaces of the backside isolation layer 106, the deep trench isolation structures 203 and the backside contact plugs 205 and 104 using CVD, PVD, PECVD, etc., or a combination thereof, followed by planarization using, for example, a CMP operation.

In the expanded backside isolation layer 116 may be formed a plurality of backside metal lines 109A and 109B through, for example, a damascene process or a direct etching operation, using a metal or a metal alloy which is the same as or different from that of the contact plugs 205 and 104. The frontside metal lines 219 may be provided to connect other circuit elements of the stacked semiconductor devices 11 and 12 to a positive voltage source, a negative voltage source, or still circuit elements of other semiconductor devices.

The backside metal lines 109A may connect the negative voltage source to the 1^{st} source/drain regions 113 through the backside contact plugs 104, and the backside metal line 109B may connect the positive voltage source to the 2^{nd} source/drain regions 123 through the backside contact plug 205 and the side via structure 217.

Thus, the 1^{st} semiconductor stack 11' and the 2^{nd} semiconductor stack 12' may be formed as a 1^{st} stacked semiconductor device 11 and a 2^{nd} stacked semiconductor device 12, respectively, in each of which the lower stack forms an NFET and the upper stack forms a PFET to complete the stacked semiconductor device 200.

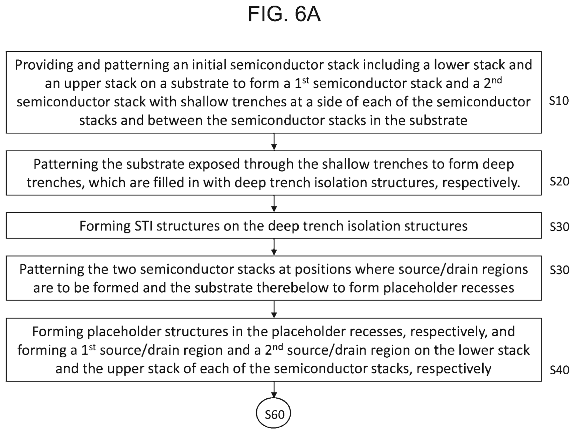

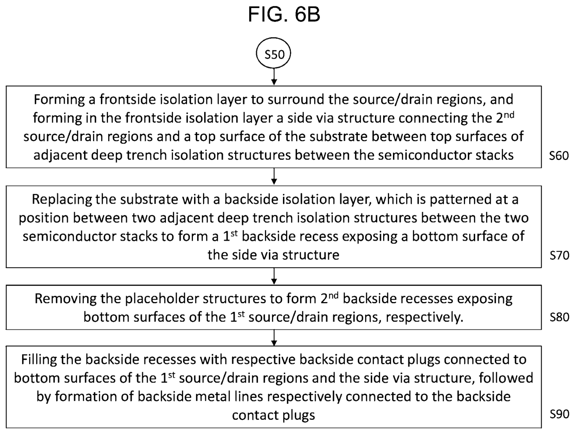

FIGS. 6A and 6B are a flowchart of manufacturing the semiconductor device 200 as shown in FIG. 2 which includes backside contact plugs for source/drain regions and a side via structure, according to one or more embodiments.

The semiconductor device to be formed through the flowchart of FIGS. 6A and 6B may be the same or similar to the semiconductor device 200 manufactured in reference to FIGS. 5A-5N.

In step S10, an initial semiconductor stack including a lower stack and an upper stack is provided on a substrate and patterned to form a 1^{st} semiconductor stack and a 2^{nd} semiconductor stack with shallow trenches at a side of each of the semiconductor stacks and between the semiconductor stacks in the substrate.

In step S20, a top surface of the substrate exposed through the shallow trenches may be patterned to form deep trenches, which are filled in with deep trench isolation structures, respectively. The deep trenches may be formed by patterning portions of the substrate at positions between which backside contact plugs for source/drain regions and a side via structure are to be formed in later steps. The deep trench isolation structures may be formed of silicon nitride or aluminum oxide.

In step S30, shallow trench isolation (STI) structures may be formed on the deep trench isolation structures in the shallow trenches.

In step S40, the two semiconductor stacks at positions where source/drain regions are to be formed and the substrate therebelow may be patterned to form respective placeholder recesses.

In step S50, placeholder structures may be formed in the placeholder recesses, respectively, and a 1^{st} source/drain region and a 2^{nd} source/drain region may be formed on the lower stack and the upper stack of each of the two semiconductor stacks, respectively.

In step S60, a frontside isolation layer may be formed to surround the source/drain regions, and a side via structure connected to the 2^{nd} source/drain regions of the two semiconductor stacks and connected to a portion of the top surface of the substrate between top surfaces of adjacent deep trench isolation structures formed between the two semiconductor stacks may be formed in the frontside isolation layer.

In step S70, the substrate may be removed and replaced by a backside isolation layer, which is patterned at a position between two adjacent deep trench isolation structures formed between the two semiconductor stacks to form a 1^{st} backside recess that exposes a bottom surface of the side via structure.

In step S80, the placeholder structures may be removed to form 2^{nd} backside recesses that expose bottom surfaces of the 1^{st} source/drain regions, respectively.

In step S90, the backside recesses may be filled in with respective backside contact plugs connected to bottom surfaces of the 1^{st} source/drain regions of the two semiconductor stacks and the side via structure, followed by formation of backside metal lines respectively connected to the backside contact plugs.

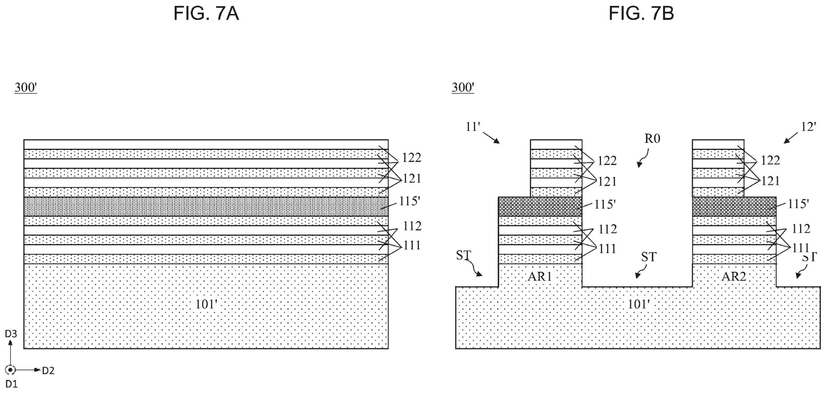

FIGS. 7A-7N illustrate intermediate semiconductor devices obtained after respective steps of manufacturing the semiconductor device 300 as shown in FIG. 3 which includes backside contact plugs for source/drain regions and a side via structure, according to one or more embodiments. Herebelow, duplicate descriptions, including those about materials and structures, thereof may be omitted and the same reference numbers may be used in the descriptions herebelow.

Referring to FIGS. 7A and 7B, an intermediate semiconductor device 300' may be formed by epitaxially growing a plurality of semiconductor layers (nanosheet layers) on a substrate 101', and the intermediate semiconductor device 300' may be patterned to obtain a 1^{st} semiconductor stack 11' and a 2^{nd} semiconductor stack 12' facing each other on the substrate 101', and also, the substrate 101' may be patterned to form a shallow trenches ST thereon. Since these steps are the same as those described in reference to FIGS. 5A and 5B, duplicate descriptions thereof may be omitted herein.

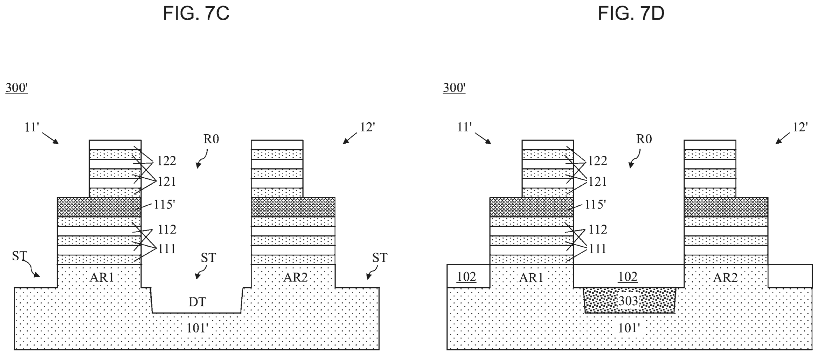

Referring to FIG. 7C, a deep trenches DT may be formed in the substrate 101' between the two semiconductor stacks 11' and 12' in the shallow trenches ST.

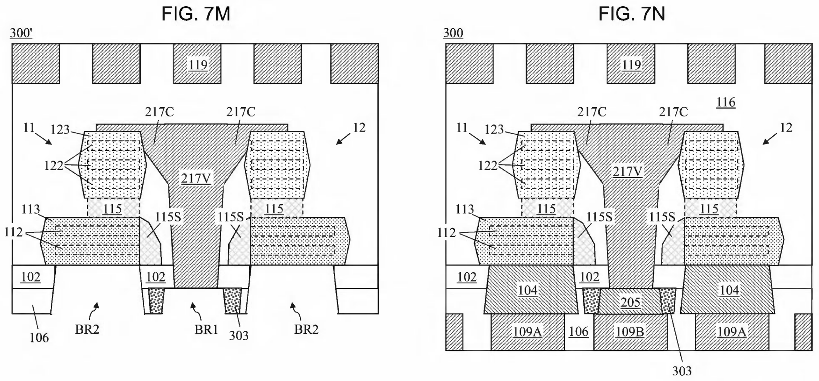

For example, the deep trenches DT may be formed by patterning portions of the substrate 101' from top at a position where a backside contact plug for a side via structure is to be formed in a later step (FIG. 7N).

To form the deep trenches DT, another drying etching operation (e.g., RIE) following the formation of the shallow trenches ST may be performed using additional hard mask patterns on the substrate 101'.

Referring to FIG. 7D, a deep trench isolation structures 303 may be formed in the deep trenches DT and shallow trench isolation (STI) structures 102 may be formed in the shallow trenches ST.

The deep trench isolation structure 303 may be formed through, for example, depositing silicon nitride (e.g., Si₃N₄) or aluminum oxide (e.g., Al₂O₃) in the deep trenches DT using chemical vapor deposition (CVD), plasma enhanced chemical vapor deposition (PECVD), physical vapor deposition (PVD), an atomic layer deposition (ALD), or a combination thereof, followed by planarization using, for example, a chemical-mechanical polishing (CMP) operation. Subsequently, the STI structures 102 may be formed on the substrate 101' with the deep trench isolation structure 303 therein in the shallow trenches ST through, for example, depositing silicon oxide (e.g. SiO₂) using CVD, PVD, PECVD or a combination thereof, followed by planarization using, for example, a CMP operation. Thus, a bottom surface of the STI structure 102 between the semiconductor stacks 11' and 12' may be on or contact top surfaces of the substrate 101' and the deep trench isolation structure 303.

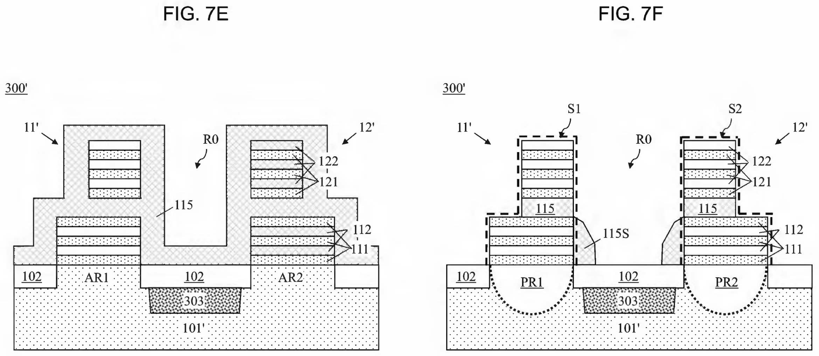

Referring to FIG. 7E, the middle sacrificial layer 115' may be removed and replaced by a middle isolation layer 115 surrounding the lower stack and the upper stack of each of the semiconductor stacks 11' and 12'. Since this step is the same as that described in reference to FIG. 5E, duplicate descriptions thereof may be omitted herein.

Referring to FIG. 7F, each of the 1^{st} semiconductor stack 11' and the 2^{nd} semiconductor stack 12' may be patterned to form spaces where a lower source/drain region and an upper source/drain region thereabove are to be formed, and further, the substrate 101' exposed by the patterning of the semiconductor stacks 11' and 12' may be patterned to form placeholder recesses PR1 and PR2 therein. At this time, the middle isolation layer 115 may also be patterned to remain only between the lower stack and the upper stack of each of the semiconductor stacks 11' and 12' and at side surfaces of the lower stacks facing each other in the D2 direction as side spacers 115S. Since this step is the same as that described in reference to FIG. 5F, duplicate descriptions thereof may be omitted herein.

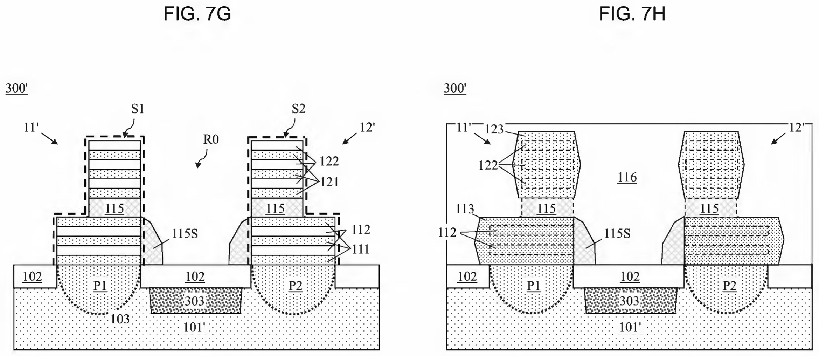

Referring to FIGS. 7G and 7H, the placeholder recesses PR1 and PR2 may be filled in with placeholder structures P1 and P2, respectively, and a 1^{st} source/drain region 113 and a 2^{nd} source/drain region 123 may be formed in each of the spaces S1 and S2 obtained by the patterning of the lower stack and the upper stack in each of the semiconductor stacks 11' and 12' in the previous step (FIG. 7F), and further, a frontside isolation layer 116 may be formed to surround the semiconductor stacks 11' and 12', thereby forming a 1^{st} stacked semiconductor device 11 and a 2^{nd} stacked semiconductor device 12. Since these steps are the same as those described in reference to FIGS 5G-5H, duplicate descriptions thereof may be omitted herein.

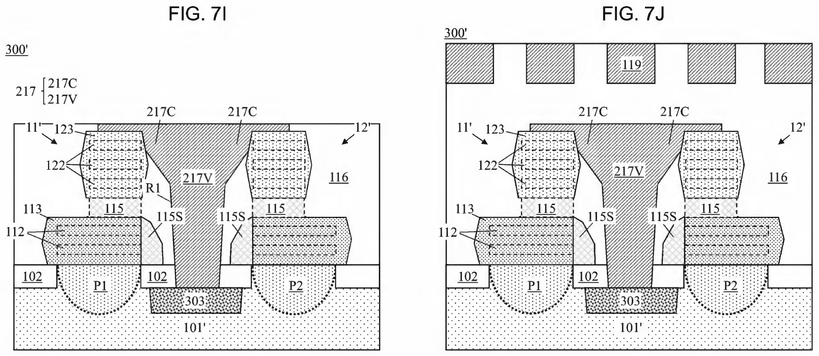

Referring to FIG. 7I, a side via structure 217 may be formed in the frontside isolation layer 116 to contact the 2^{nd} source/drain regions 123 of the semiconductor stacks 11' and 12' and extend down to contact a top surface of the deep trench isolation structure 303 formed in the substrate 101' through the STI structure 102 between the stacked semiconductor devices 11 and 12.

The side via structure 217 may be formed to connect the 2^{nd} source/drain regions 123 to a positive voltage source through a backside contact plug and a backside metal line to be formed in a later step (FIG. 7N).

To form the side via structure 217, the frontside isolation layer 116 may be patterned therein through, for example, dry etching or wet etching to form a recess R1 exposing at least a portion of a top surface and at least a portion of a side surface of each of the 2^{nd} source/drain regions 123 and a portion of the top surface of the deep trench isolation structure 303 formed in the substrate 101' between the semiconductor stacks 11' and 12'. Subsequently, the side via structure 217 may be formed in the recess R1 through, for example, depositing a metal or a metal alloy therein using CVD, PVD, PECVD or a combination thereof, followed by planarization using, for example, a CMP, operation so that the side via structure 217 may connect the at least a portion of the top surface and at least a portion of the side surface of each of the 2^{nd} source/drain regions 123 to a portion of the top surface of the deep trench isolation structure 303 between the semiconductor stacks 11' and 12'..

Structural characteristics of the side via structure 217 in the intermediate semiconductor device 300' may be the same as those of the side via structure 217 in the intermediate semiconductor device 200', and thus, duplicate descriptions thereof may be omitted herein.

Referring to FIG. 7J, an additional isolation material is formed on the top surface of the frontside isolation layer 116 to expand the frontside isolation layer 116 and a plurality of frontside metal lines 119 may be formed above the side via structure 217. Since this step is the same as that described in reference to FIG. 5J, duplicate descriptions thereof may be omitted herein.

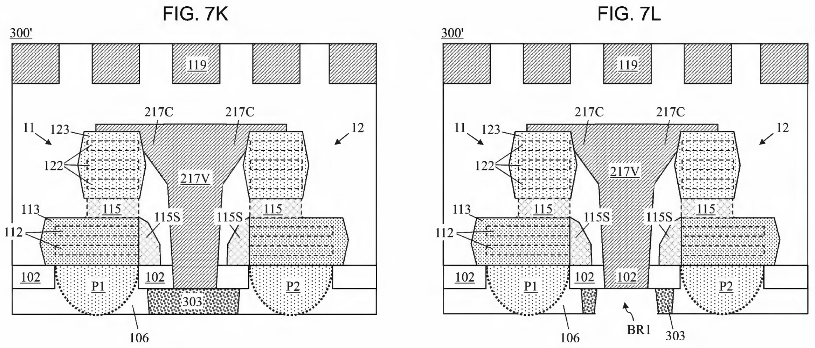

Referring to FIG. 7K, the substrate 101' may be thinned to expose the placeholder structures P1 and P2 and the deep trench isolation structure 103 and the remaining substrate 101' may be removed and replaced by a backside isolation layer 106.

The substrate 101' may be thinned through, for example, a backside thinning operation in which the substrate 101' is mechanically grinded to expose bottom surfaces of the placeholder structures P1 and P2 and the deep trench isolation structure 103, followed by dry etching or wet etching to remove the remaining substrate 101' surrounding the placeholder structures P1 and P2 and the deep trench isolation structure 103.

A space obtained by the removal of the substrate 101' may be filled in with a low-k material such as silicon oxide (e.g., SiO₂) to form the backside isolation layer 106, followed by planarization using, for example, a CMP operation to expose bottom surfaces of the placeholder structures P1 and P2 and the deep trench isolation structures 103 again.

To perform the substrate removal operation in this step and the subsequent backside operations, the intermediate semiconductor device 300' obtained in the previous step (FIG. 7J) may be turned upside down to facilitate the backside operations.

Referring to FIG. 7L, a portion of the deep trench isolation structure 303 vertically below the side via structure 217 may be removed to form a 1^{st} backside recess BR1 in the deep trench isolation structure 303 to expose a bottom surface of the side via structure 217.

The removal of the portion of the deep trench isolation structure 303 in this step may be performed through, for example, dry etching or wet etching using an etchant such as hot phosphoric acid based on hard mask patterns formed on a bottom surface of the deep trench isolation structure 203, thereby exposing the bottom surface of the side via structure 217 through the backside recess BR1.

Referring to FIG. 7M, the backside isolation layer 106 surrounding the placeholder structures P1 and P2 may be removed through, for example, dry etching or wet etching using an etchant such as hydrofluoric acid (HF) using hard mask patterns formed on a bottom surface of the backside isolation layer 106 to form 2^{nd} backside recesses BR2 to expose bottom surfaces of the 1^{st} source/drain regions 213 of the respective semiconductor stacks 11' and 12'.

Referring to FIG. 7N, the backside recesses BR1 and BR2 respectively exposing the bottom surfaces of the side via structure 217 and the 1^{st} source/drain regions 213 may be filled in with backside contact plugs 205 and 104, respectively, thereby completing a semiconductor device 300. Since this step is the same as that described in reference to FIG. 5N, duplicate descriptions thereof may be omitted herein.

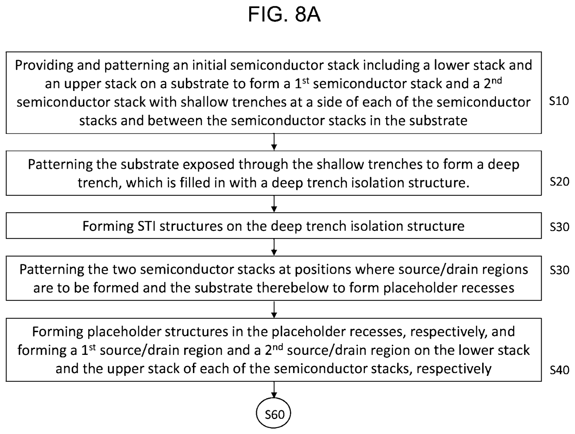

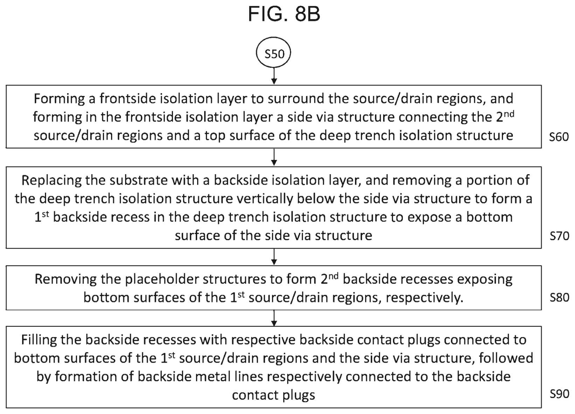

FIGS. 8A and 8B are a flowchart of manufacturing the semiconductor device 300 as shown in FIG. 3 which includes backside contact plugs for source/drain regions and a side via structure, according to one or more embodiments.

The semiconductor device to be formed through the flowchart of FIGS. 8A and 8B may be the same or similar to the semiconductor device 300 manufactured in reference to FIGS. 7A-7N.

In step S10, an initial semiconductor stack including a lower stack and an upper stack is provided on a substrate and patterned to form a 1^{st} semiconductor stack and a 2^{nd} semiconductor stack with shallow trenches at a side of each of the semiconductor stacks and between the semiconductor stacks in the substrate.

In step S20, a top surface of the substrate exposed through a shallow trench between the two semiconductor stacks may be patterned to form a deep trench, which is filled in with a deep trench isolation structure. The deep trench may be formed by patterning a portion of the substrate at a position in which a backside contact plug for a side via structure is to be formed in later steps. The deep trench isolation structure may be formed of silicon nitride or aluminum oxide.

In step S30, shallow trench isolation (STI) structures may be formed on the deep trench isolation structure in the shallow trenches.

In step S40, the two semiconductor stacks at positions where source/drain regions are to be formed and the substrate therebelow may be patterned to form respective placeholder recesses.

In step S50, placeholder structures may be formed in the placeholder recesses, respectively, and a 1^{st} source/drain region and a 2^{nd} source/drain region may be formed on the lower stack and the upper stack of each of the two semiconductor stacks, respectively.

In step S60, a frontside isolation layer may be formed to surround the source/drain regions, and a side via structure connected to the 2^{nd} source/drain regions of the two semiconductor stacks and connected to a portion of a top surface of the deep trench isolation structure may be formed in the frontside isolation layer.

In step S70, the substrate may be removed and replaced by a backside isolation layer, and a portion of the deep trench isolation structure vertically below the side via structure may be removed to form a 1^{st} backside recess in the deep trench isolation structure to expose a bottom surface of the side via structure.

In step S80, the placeholder structures may be removed to form 2^{nd} backside recesses that expose bottom surfaces of the 1^{st} source/drain regions, respectively.

In step S90, the backside recesses may be filled in with respective backside contact plugs connected to bottom surfaces of the 1^{st} source/drain regions of the two semiconductor stacks and the side via structure, followed by formation of backside metal lines respectively connected to the backside contact plugs..

In the above embodiments, each of the stacked semiconductor device 11 and 12 has different-width channel structures and different-width source/drain regions at the 1^{st} level and the 2^{nd} level. However, the disclosure is not limited thereto. The side via structures 217 and 417, the backside contact plug 205 on the side via structures 217 and 417, and the deep trench isolation structures 203 and 303 shown in FIGS. 2-4 may also be formed in a semiconductor device formed of stacked semiconductor devices having the same-width channel structures and the same-width source/drain regions at the 1^{st} level and the 2^{nd} level, according to one or more embodiments. In this case, the side spacer 115S may not be formed on a side surface of a 1^{st} source/drain region at the 1^{st} level. Moreover, the side via structures 217 and 417, the backside contact plug 205 on the side via structures 217 and 417, and the deep trench isolation structures 203 and 303 shown in FIGS. 2-4 may be formed in a semiconductor device including single-stack semiconductor devices, according to one or more embodiments. For example, the semiconductor device 200 may be formed to include only the 2^{nd} FETs at the 2^{nd} level without the 1^{st} FETs at the 1^{st} level, in which case the backside contact plugs 104 may be connected to the 2^{nd} source/drain regions 123 while the side via structure 217 is still connected to the 2^{nd} source/drain regions 123.

Further, at least one of the 1^{st} FET and the 2^{nd} FET forming the stacked semiconductor devices 11 and 12 may be replaced by a different type of FET (e.g., FinFET) other than the nanosheet transistor, according to one or more embodiments.

In the above embodiments, the semiconductor device 100, 200, 300 and 400 may all form an inverter circuit in the semiconductor cell 10, for which the side via structures 117, 217 and 417 connect the 2^{nd} source/drain regions 123 to the positive voltage source, and the backside contact plugs 104 connect the 1^{st} source/drain regions 113 to the negative voltage source. However, the disclosure is not limited thereto. The side via structures 117, 217 and 417, the backside contact plug 205 on the side via structures 217 and 417, and the deep trench isolation structures 203 and 303 shown in FIGS. 2-4 may be formed to connect the at least one of the 1^{st} source/drain regions 113 and the 2^{nd} source/drain regions 123 to another circuit element for signal routing purpose to form a different type of circuit or logic circuit, according to one or more embodiments.

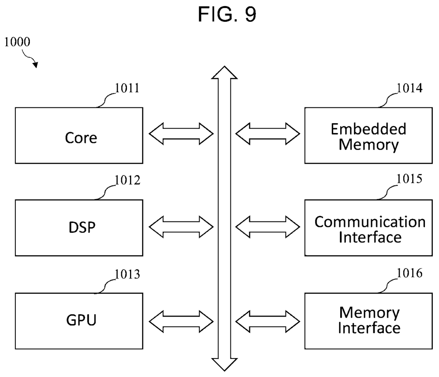

FIG. 9 is a schematic block diagram illustrating an electronic device including one or more semiconductor devices including backside contact plugs for source/drain regions and a side via structure, according to one or more embodiments. The semiconductor devices of the electronic device may include one or more of the semiconductor devices 100, 200, 300 and 400 shown in FIGS. 1B, 2, 3 and 4, according to one or more embodiments.

Referring to FIG. 9, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus 1007.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (DRAM), a flash memory, etc.

At least one of the core 1011, the DSP 1012, the GPU 1013, and/or the embedded memory 1014 may include one or more of the semiconductor devices 100, 200, 300 and 400 shown in FIGS. 1B, 2, 3 and 4, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a 1^{st} source/drain region (113);
a 2^{nd} source/drain region (123) above the 1^{st} source/drain region (113);
a side via structure (217; 417) connected to the 2^{nd} source/drain region (123);
a 1^{st} backside contact plug (104) on the 1^{st} source/drain region (113);
a 2^{nd} backside contact plug (205) on the side via structure (217; 417);
a 1^{st} backside metal line (109A) on the 1^{st} backside contact plug (104); and
a 2^{nd} backside metal line (109B) on the 2^{nd} backside contact plug (205).

2. The semiconductor device of claim 1, further comprising a 1^{st} deep trench isolation structure (203; 303) on a side surface of the 2^{nd} backside contact plug (205).

3. The semiconductor device of claim 2, further comprising a 2^{nd} deep trench isolation structure (203; 303) on an opposite side surface of the 2^{nd} backside contact plug (205).

4. The semiconductor device of claim 2 or 3, further comprising a shallow trench isolation, STI, structure (102) above the 1^{st} deep trench isolation structure (203; 303).

5. The semiconductor device of claim 4, wherein the 1^{st} deep trench isolation structure (203; 303) and the STI structure (102) comprise different material compositions.

6. The semiconductor device of claim 4 or 5, wherein the STI structure (102) is on the side surface of the 2^{nd} backside contact plug (205).

7. The semiconductor device of any one of claims 2 to 6, wherein the 1^{st} deep trench isolation structure (203) is also on a side surface of the 1^{st} backside contact plug (104) facing the side surface of the 2^{nd} backside contact plug (205).

8. The semiconductor device of claim 7, further comprising a 3^{rd} deep trench isolation structure on an opposite side surface of the 1^{st} backside contact plug.

9. The semiconductor device of claim 8, further comprising a shallow trench isolation, STI, structure above the 1^{st} deep trench isolation structure,
wherein the STI structure is on the side surface of the 1^{st} backside contact plug (104).

10. The semiconductor device of any one of claims 1 to 9, further comprising:
a shallow trench isolation, STI, structure (102) on a lower side surface of the side via structure; and
a backside isolation layer (106) below the STI structure,
wherein a bottom surface of the side via structure (217; 417) is at a level of a bottom surface of the STI structure (102).

11. A semiconductor device comprising:
a source/drain region (113);
a backside contact plug (104) on a bottom surface of the source/drain region (113); and
a 1^{st} deep trench isolation structure (203) on a side surface of the backside contact plug (104).

12. The semiconductor device of claim 11, further comprising a shallow trench isolation, STI, structure (102) above the 1^{st} deep trench isolation structure (203),
wherein the STI structure (102) is also on the side surface of the backside contact plug (104).

13. The semiconductor device of claim 12, wherein the 1^{st} deep trench isolation structure (203) and the STI structure (102) have different material compositions.

14. The semiconductor device of any one of claims 11 to 13, further comprising a 2^{nd} deep trench isolation structure on an opposite side surface of the backside contact plug (104).

15. The semiconductor device of any one of claims 11 to 14, wherein a bottom surface of the backside contact plug (104) is at a same level as a bottom surface of the 1^{st} deep trench isolation structure (203).
